Europäisches Patentamt

European Patent Office

Office européen des brevets

(19)

(11) Publication number: **0 471 844 A1**

## (12) EUROPEAN PATENT APPLICATION
### published in accordance with Art. 158(3) EPC

(21) Application number: **90907402.3**

(22) Date of filing: **07.05.90**

(86) International application number:
**PCT/JP90/00582**

(87) International publication number:
**WO 90/13912 (15.11.90 90/26)**

(51) Int. Cl.5: **H01L 21/316**, H01L 29/784,
H01L 29/78

(30) Priority: **07.05.89 JP 113959/89**

(43) Date of publication of application:
**26.02.92 Bulletin 92/09**

(84) Designated Contracting States:
**AT BE DE DK FR GB IT LU NL SE**

(71) Applicant: **OHMI, Tadahiro**
**1-17-301, Komegabukuro 2-chome Aoba-ku**
**Sendai-shi Miyagi-ken 980(JP)**

(72) Inventor: **OHMI, Tadahiro**

**1-17-301, Komegabukuro 2-chome Aoba-ku**
**Sendai-shi**
**Miyagi-ken 980(JP)**
Inventor: **MORITA, Mizuho**
**1-3, Komegabukuro 2-chome Aoba-ku**
**Sendai-shi**
**Miyagi-ken 980(JP)**

(74) Representative: **Weitzel, Wolfgang, Dr.-Ing.**
**Friedenstrasse 10**
**W-7920 Heidenheim(DE)**

(54) SILICON OXIDE FILM AND SEMICONDUCTOR DEVICE HAVING THE SAME.

(57) A silicon oxide film in which the peak bond energy of an $Si_{2p}$ of a silicon-oxygen bond is greater than that of an $Si_{2p3/2}$ of a silicon-silicon bond by more than 4.1 eV in X-ray photoelectron spectroscopy.

Fig. 1

EP 0 471 844 A1

(Technical Field)

The present invention relates to a silicon oxide film and a semiconductor having the oxide film, and more particularly to a silicon oxide film with a large bond energy between oxygen and silicon atoms and the semiconductor device having the silicon oxide film.

(Background Of the Invention)

In a prior art semiconductor device, insulator films have been formed by thermal oxidation. For example, an oxide film is formed at a high temperature of e.g. more than 600 °C by bringing a silicon substrate into contact with gas such as dry oxygen, dry oxygen containing a slight amount of hydrogen chloride, or oxygen containing moisture. However, such a method cannot be applied to the low temperature process since the formation of oxide film is carried out at high temperature.

The importance of the low temperature process is described below by reference to the formation of the oxide film of MOS LSI.

A rapid advancement has been made in the LSI technology and DRAM with more than 1 Mbit has already been put into practice. In order to manufacture a high efficiency electronic devices, i.e. devices with ultrafine pattern and ultra high integration, a highly controlled process which is not affected by various indeterminate factors is required. The low temperature process is cited as such a process.

For example, lowering the formation temperature of an oxide film results in decrease of the impurities released from materials constituting a reaction system. Consequently, the trap density in an oxide film and at the interface between the oxide film and silicon are reduced, and therefore an electrically stable semiconductor device can be realized.

The low temperature process is also effective to decrease the deformation of silicon substrate, and the strain and the defect density in materials constituting a semiconductor device.

Furthermore, if the formation temperature of an oxide film is lower than 600 °C, an oxide film can be formed even after the formation of metal or metal alloy with low melting point such as aluminum. Therefore, semiconductor having various functions can be realized. Temperature less than 500 °C is particularly desirable since no hillock generates in an aluminum thin film.

As mentioned above, lowering the formation temperature of oxide film is inevitable to realize ultrafine patterned LSI.

In a prior art technology, ultrafine patterned LSI and therefore high efficiency semiconductor device have not been realized because of high temperature process.

The purpose of the present invention is to provide an oxide film having an excellent dielectric characteristic and to provide a high speed semiconductor device with high conductance and short channel.

(Disclosure Of The Invention)

The above-mentioned purpose is attained by a silicon oxide film in which a bond energy of an $Si_{2p}$ peak of a silicon bond is greater than that of an $Si_{2p3/2}$ peak of a silicon-silicon bond by more than 4.1 eV in X-ray photoelectron spectrum and semiconductor device having such a silicon oxide film.

(Brief Description Of The Drawings)

Fig. 1 is a diagram showing the thickness of oxide film to be formed on a silicon surface in ultra pure water as a function of elapsed time.

Fig. 2 is a cross-sectional view of a semiconductor device according to the embodiment of the invention.

Fig. 3 are cross-sectional views of a semiconductor device showing manufacturing process thereof.

| 11 | Electrode on the back of a substrate |
| 12 | $p^+$ substrate |
| 13 | $n^+$ buried region |
| 14 | High resistance $p^-$ region |
| 15 | High resistance $n^-$ region |
| 16 | Isolation region |
| 17,18 | $n^+$ region |
| 19,20 | $p^+$ region |
| 21,22,23,24 | Metal silicide |

2

| 25,26 | Silicon oxide film (gate insulating film) |
| 27,28 | Gate electrode |
| 29,30,31 | Metal electrode |
| 32,33,34 | Metal fluoride (AlF$_3$) |
| 35 | PSG film, nitride film |

(Description Of Preferred Embodiment)

The embodiments of the present invention are described by referring to the figures.

The formation of oxide film of a semiconductor device is carried out by the following method. Namely, a method of forming oxide film comprises;

a first step in which an oxide film is formed on a substrate surface by bringing the substrate in contact with an aqueous solution in which oxygen and/or oxygen-containing molecule is dissolved, and

a second step in which a bond between oxygen and silicon atoms in the oxide film is strengthened by thermally treating the oxide film at a temperature range of 20 to 600 °C in the atmosphere of oxygen, oxygen-containing molecule, inert gas, or a mixture of two or more of them.

(The invention referring to the forming method was also applied for patent on the same day.)

The forming method of a silicon oxide film is described in detail.

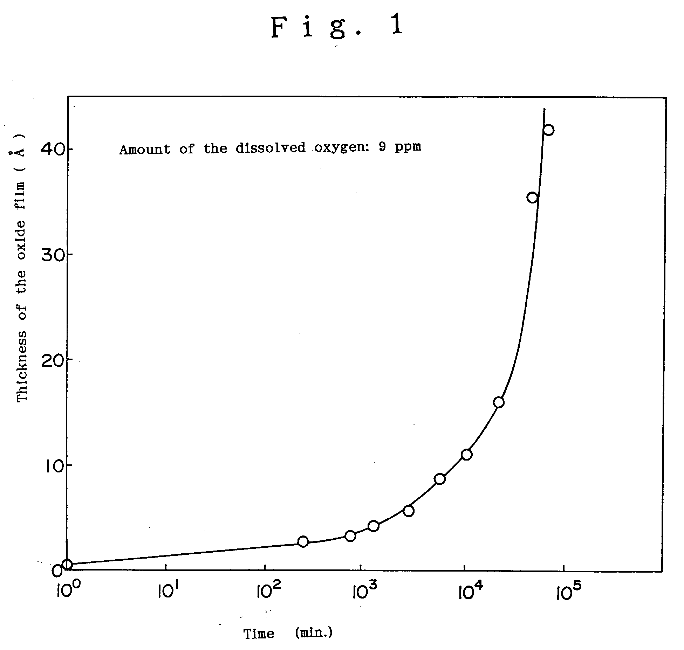

Fig. 1 is a diagram showing the change of the thickness of oxide film formed on a silicon surface with time when a silicon substrate is immersed in the ultra pure water containing 9 ppm oxygen by volume. The thickness of the oxide film was measured with an ESCA and an elipsometer. In Fig. 1, the thickness of the oxide film formed on the silicon substrate is plotted as ordinate, and the elapsed time after the substrate being immersed in ultra pure water at 23 °C is plotted as abscissa.

As is shown in Fig. 1, the oxide film of 4.2 nm in thickness was formed after a silicon wafer had been placed in the pure water containing dissolved oxygen of 9 ppm for 46 days.

Table 1 shows the thickness of the oxide film and bond energy between silicon and oxygen atoms in the film after the oxide film of 4.2 nm in thickness which had been formed in the pure water was heated at 500 °C in oxygen gas or nitrogen gas atmosphere for 1 hour.

The values of bond energy shown in Table 1 are the difference of bond energy between an Si$_{2p}$ peak of a silicon-oxygen bond and an Si$_{2p3/2}$ of a silicon-silicon bond in X-ray photoelectron spectrum.

Table 1

| | oxide film, nm | bond energy, eV |
|---|---|---|
| after 46 days in pure water | 4.20 | 4.49 |
| after O$_2$ anneal at 500 °C for 1hour | 4.96 | 4.87 |
| after N$_2$ anneal at 500 °C for 1hour | 3.98 | 4.72 |

The thickness of the oxide film increased to 4.9 nm after the thermal treatment ( annealing ) in oxygen gas, and decreased slightly to 3.98 nm after the thermal treatment in nitrogen gas. The bond energy increased after the thermal treatment in both oxygen and nitrogen gas. The bond energy of the oxide film thus prepared is greater than that of the oxide film which is formed on the silicon surface in dry oxygen at 800 °C.

It has been found that the oxide film of more than 3 nm in thickness and large bond energy between silicon and oxygen atoms can be formed by the method; for example, by heating a silicon substrate in oxygen gas or nitrogen gas atmosphere after the substrate being immersed in pure water containing 9 vol. ppm oxygen.

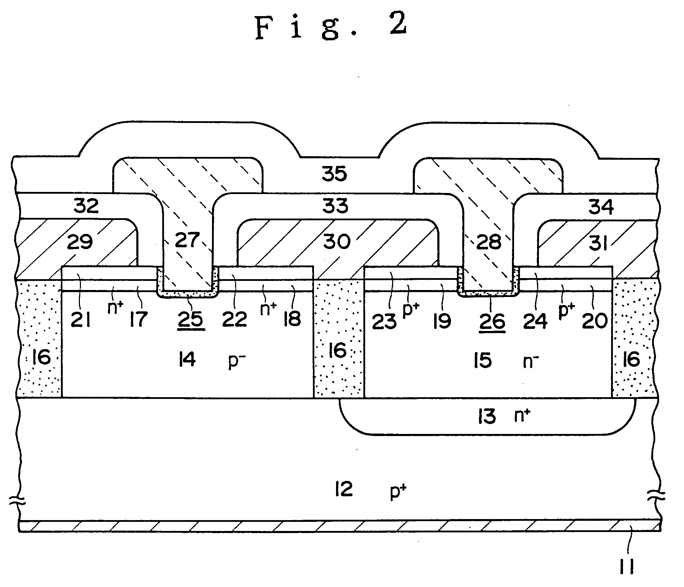

It is impossible by a prior art thermal oxidation method to form an oxide film with a thickness of more than 3 nm at a temperature of less than 600 °C. The present inventors have also found out that an oxide film with a thickness of 4.81 nm and a bond energy of 4.64 eV is formed by the thermal treatment at 800 °C for 20 minutes in ultra pure atmosphere in which impurities such as moisture and carbon dioxide are reduced to less than tens of ppb, or preferably to several ppb. However, such an oxide film cannot be applied to a semiconductor device shown in Fig. 2 in which electrodes 29, 30, 31 are made of Al. This oxide film can be used only in the case that electrode regions 29, 30, 31 are made of materials having a high melting point such as Mo, W, Ta, Ti, Pd, or silicides of these metal. On the other hand, the present method can be applied to not only the case that the regions 29, 30, 31 are made of high melting point materials, but also to the case that the regions are made of Al. Furthermore, it is also possible to increase the bond energy to more than 4.64 eV by the present method.

The aqueous solution in which oxygen and/or oxygen-containing molecule is dissolved, used in the first step of the method, is an aqueous solution containing oxygen, an aqueous solution containing ozone, hydrogen peroxide, a sulfuric acid and hydrogen peroxide solution, a hydrogen chloride and hydrogen peroxide solution, or an ammonia and hydrogen peroxide solution for example. Here, it is also possible to use a solution in which oxygen is dissolved in hydrogen peroxide.

In the first step, an oxide film is formed on a substrate by bringing a substrate surface in contact with a solution in which oxygen and/or oxygen-containing molecule is dissolved. Here, it is preferable because the formation rate of the oxide film is increased that the solution is brought into contact with a catalyst to accelerate the decomposition of the molecule contained in the solution. Therefore, when the substrate is brought in contact with the solution with dissolved oxygen of e.g. 0.1 vol ppm, the adoption of the catalyst makes it possible to use the solution with dissolved oxygen less than 0.1 vol. ppm at the beginning.

As an example of a solid catalyst, platinum is used. The contact of hydrogen peroxide with a platinum catalyst cause to generate oxygen radical from hydrogen peroxide, and as a result, the effect on the formation rate of an oxide film becomes remarkable. For example, 1 nm thick oxide film is formed at room temperature in 30 minutes, and 2 to 5 nm thick film is formed at 70 to 85 °C in 24 hours. Namely, the oxide film used for e.g. gate oxide film of MOS LSI can be obtained in short time to be put into practical application. It is desirable to use hydrogen peroxide which contains no stabilizer. The content of TOC in hydrogen peroxide is required to be less than 1 ppm and is preferable to be less than 0.1 ppm. Also in other solutions, impurities content less than 1ppm is desirable and less than 0.1 ppm is preferable.

In the first step of the method, when the content of dissolved oxygen or oxygen-containing molecule in an solution is more than 0.1 vol ppm, the oxide film is formed on the silicon substrate surface in relatively short time, and the formation rate of the oxide film increases as the content of dissolved oxygen or oxygen-containing molecule increases .

Though the solubility limit of oxygen is 14 ppm in aqueous solution at 0 °C and at atmospheric pressure, it is possible to increase the content of dissolved oxygen in the following manner. Namely, the content of dissolved oxygen or oxygen-containing molecule can be increased by, e.g., immersing a silicon substrate into ultra pure water in a closed vessel, by introducing oxygen gas into the vessel, and then by increasing the pressure of oxygen.

The upper limit value of 10000 vol. ppm is desirable as the content of oxygen and/or oxygen-containing molecule.

In the second step of the process, the same oxygen-containing molecule as used in the first step can also be used in vapor phase. The inert gas is nitrogen gas, argon gas or helium gas. Oxygen, oxygen-containing molecule, inert gas or a mixture of them are also used. In order to increase the bond energy, it is desirable to reduce the impurities in the vapor phase such as moisture or hydrocarbon to less than tens of ppb, and preferable to less than 0.1 ppb.

In the case that oxygen or oxygen-containing molecule is contained in the atmosphere in the second step, the formation rate of the oxide film increases remarkably. A temperature range of 20 to 600 °C is desirable and a range of 100 to 500 °C is preferable. Furthermore, the temperature close to 500 °C is better from the practical point of view because the film can be formed in shorter time.

The temperature of thermal treatment in the second step is set to be as high as possible only if the wafer condition is allowed. The pressure of the atmosphere is not restricted; therefore any condition such as reduced pressure, atmospheric pressure or high pressure condition is available.

Next, a semiconductor device according to the embodiment of the present invention is described by reference to figures.

Fig. 2 is a cross-sectional view of the semiconductor device according to the embodiment. Only one CMOS element of the semiconductor device is drawn in the figure. Here, 11 is an electrode on the back of a substrate, 12 is a $p^+$ substrate, 13 is an $n^+$ buried layer, 14 is a $p^-$ high resistance region, 15 is an $n^-$ high resistance region, 16 is an isolation region, 17 and 18 are $n^+$ regions, 19 and 20 are $p^+$ regions, 21, 22, 23, and 24 are metal silicide such as $MOSi_2$, $WSi_2$, $TaSi_2$ or $Pd_2Si$, 25 and 26 are silicon oxide films (gate insulating film) formed in the same manner as mentioned previously, 27 and 28 are gate electrodes, 29, 30 and 31 are metal electrodes such as Al, AlSi or AlCu, 32, 33 and 34 are metal fluoride films for electrically separating electrodes 27, 28, 29 and 30; for example, $AlF_3$ when Al is used as an electrode, and 35 is a PSG film or a nitride film for passivation.

In Fig. 2, the interface between gate insulating film 25 and region 14 is formed deeper in the region 14 than those between regions 17, 18 and region 14. The interface between gate insulating film 26 and region 15 is also formed deeper in the region 15 than those between regions 19, 20 and region 15. The short-channel effect does not easily occur in this structure because the electric field between source and drain is weakened in the channel.

In Fig.2, gate electrodes 27, 28 are preferably made of material such as Al, AlSi or AlCu which has a large diffusion potential or built-in potential to both $n^+$ region 17, 18 and $p^+$ region 19,20. For example, Al has a diffusion potential or built-in potential of about 0.7V to $n^+$ region and of about 0.4 V to $p^+$ region. The selected material of electrode is a matter of design choice provided that the work function of the electrode have a large barrier to both $n^+$ region and $p^+$ region. Thus, a high melting point metal or a metal silicide is also available. Therefore, the resistance of gate electrode is small. In this structure, the diffusion potentials or built-in potentials of $p^+$ substrate and gate electrode 27 to $n^+$ source region and those of $n^+$ buried region 13 and gate electrode 28 to $p^+$ source region produce potential barrier in the channel, and therefore normally-off characteristic of MOS transistor is attained at a low impurity concentration of $10^{14}$ to $10^{16}$ $cm^{-3}$ in channel regions 14, 15. Namely, the regions 14, 15 are of high resistance, and the concentration of impurities is maintained low. The channels which electrons or holes pass through are maintained wide and therefore short channel is realized without causing decrease in mobility of carrier. Consequently, MOS transistor with large conversion conductance $g_m$ can be obtained.

In Fig.2, a junction plane between $n^+$ region 17 and region 14, that between $n^+$ region 18 and region 14, that between $p^+$ region 19 and region 15, and that between $p^+$ region 20 and region 15 are flat and of small area, resulting in small fringe effect and small capacitance between a source region and a substrate, between a drain and a substrate, and between a source region and a drain region.

In Fig.2, electrodes 29, 30, 31 are made of e.g. Al, AlSi, AlCu and AlCuSi, and therefore resistance of source and drain electrodes are small. Because of small resistance of source, drain and gate, of small capacity of a source and drain capacitor, and of large conversion conductance $g_m$, the transistor has high speed performance characteristic. Metal such as Mo, W, Ta and Ti can also be used as a source and a drain electrodes.

By using a semiconductor device having the oxide film formed by the process mentioned previously, semiconductor integrated circuit composed of a high speed insulated gate transistor can be realized.

A $p^+$ substrate 12 with a buried region 13 is used in Fig.2. As a substrate of the semiconductor device, insulator substrates such as sapphire, spinel, quartz, AlN or SiC are also available.

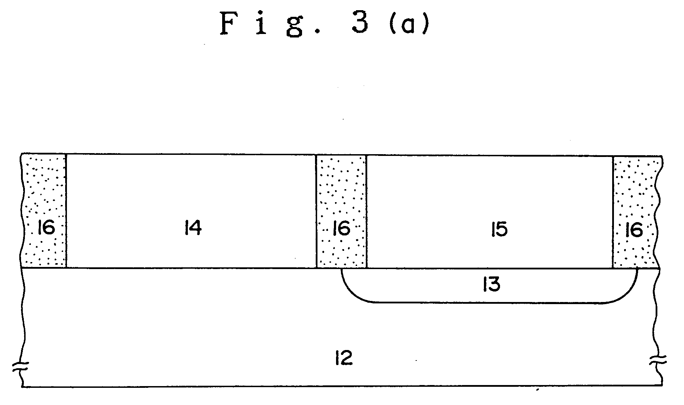

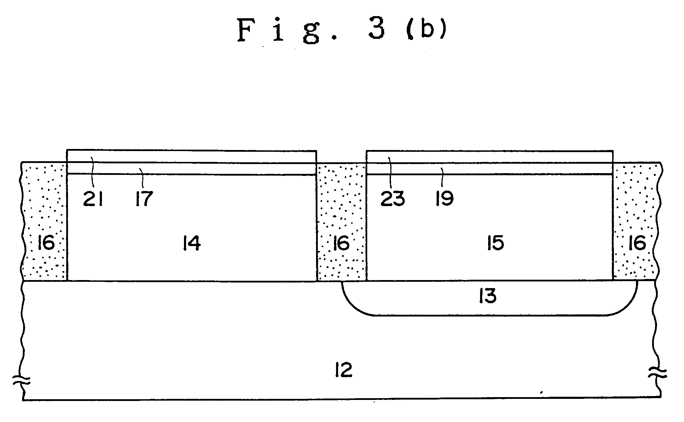

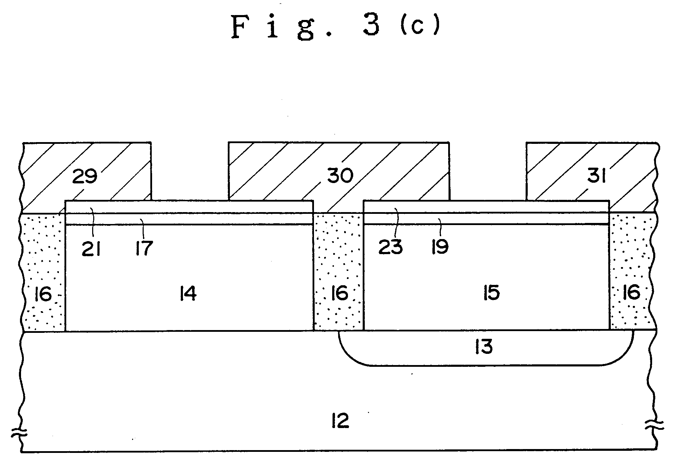

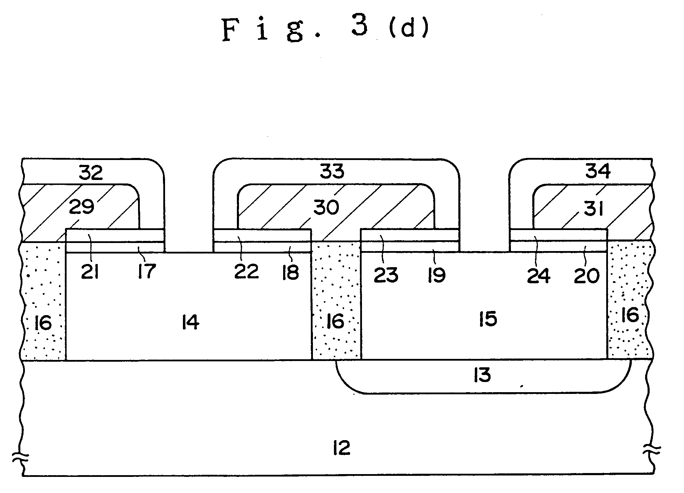

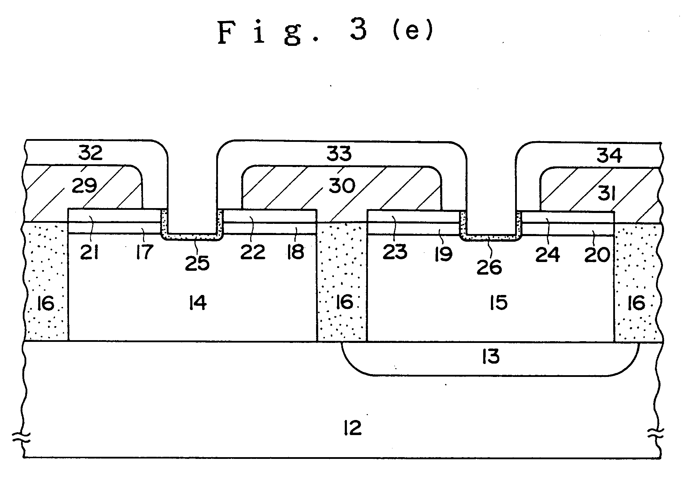

In Fig.3, shown is an example of manufacturing process of the semiconductor device shown in Fig. 2. Here, explanation is made for the case that a $p^+$ substrate is used as a substrate.

First, $n^+$ buried region is formed by diffusing P from a PSG film deposited on the region 13 of $p^+$ substrate 12 by e.g. CVD method. The region 13 can also be formed by ion implantation of P or As and following annealing for activation. Isolation region 16, $p^-$ region 14 and $n^-$ region 15 are formed in the following manner. For example, after the thermal oxidation film of tens of nm thickness is formed on the surface of the substrate 12 having buried region 13, a PSG film or BPSG film of prescribed thickness is deposited. The portion corresponding to the region 14, 15 in the thermal oxidation film and PSG film or BPSG film is removed by reactive ion etching. Then, selective epitaxial film is formed on regions 14, 15 by the use of e.g. CVD method using $SiH_4$, $Si_2H_6$ or $SiH_2Cl_2$

In this manner, the structure shown in Fig. 3(a) is constructed. The manufacturing method is not restricted by that mentioned above and the selected thickness of region 14,15 is a matter of design choice. Thickness of 0.03 - 0.5 $\mu$m is typically selected.

Next, only on the surface of the regions 14, 15 is selectively deposited metal layer of 10 to 20 nm in thickness, such as W, Ta, Ti and Mo. Then, for example, As is implanted into region 14, and B and Si are implanted into region 15 through the metal layer by ion implantation. Thereafter annealing is carried out for activation. Thus, regions 21, 22, 23, 24 of metal silicide layer, $n^+$ region 17, 18 and $p^+$ region 19, 20 are formed as shown in Fig. 3(b). Then, Al film of 0.2 to 1.0 $\mu$m thickness is deposited by sputtering or CVD and then prescribed portions are removed by reactive ion etching as shown in Fig. 3(c). The surface of region 29, 30, 31 is fluorinated at e.g. 100 $°$C for 4 hours by using ultra pure $F_2$ gas and then annealed at 150 $°$C in inert gas such as nitrogen gas for 5 hours to form insulator layer of $AlF_3$ which is shown as region 32, 33, 34 on the Al surface in Fig.3(d).

As shown in Fig. 3(d), contact holes are formed by etching prescribed portions of metal silicide, n$^+$ region and p$^+$ region. In this etching process, the regions 32, 33, 34 act as a mask.

By the oxidation treatment mentioned previously, the oxide films are formed on the exposed surface inside the contact holes. Namely, the oxide films are formed at a temperature less than 500 °C on silicide layer, n$^+$ region and p$^+$ region, as shown in Fig.3(e).

Furthermore, after the formation of gate electrode 27, 28, the etching of prescribed portion thereof and the formation of passivation layer 35 and electrode 11, the semiconductor device shown in Fig. 2 is constructed.

(Experiment for comparison)

Two pieces of silicon wafer were immersed in 30% hydrogen peroxide solution which was in contact with a platinum catalyst. After 1 hour, an oxide film of 7 A in thickness was formed on the silicon wafer. The oxide film thus formed was such that the difference of bonding energy between $Si_{2p}$ peak due to a silicon-oxygen bond and $Si_{2p3/2}$ peak due to a silicon-silicon bond was 3.99 eV in X-ray photoelectron spectrum. This oxide film is described as the oxide film 1 hereinafter.

One of two wafers on which the oxide film 1 had been formed was thermally treated at 800 °C for 1 hour in nitrogen gas containing impurities of less than several ppb. After this treatment, the thickness of the oxide film became 9 A and the difference of the bonding energy became 4.22 eV between $Si_{2p}$ peak due to a silicon-oxygen bond and $Si_{2p3/2}$ peak due to silicon-silicon bond in X-ray photoelectron spectrum. The oxide film after thermal treatment is described as the oxide film 2.

Both the wafer with the oxide film 1 and that with the oxide film 2 were placed in the atmosphere containing hydrogen fluoride of 0.6 to 1.3 vol.% and moisture of $10^{-2}$ to 5 ppm. The oxide film 1 was easily removed but the oxide film 2 was not removed, indicating that the oxide film 2 can be used as a mask in etching process.

An electric voltage of 1 V was applied to the oxide films 1 and 2. An electric current passing through the oxide film 1 was more than 1 A/cm$^2$; on the other hand, a current passing through the oxide film 2 was less than 1 x $10^{-4}$ A/cm$^2$. Thus, the film with the bonding energy difference between $Si_{2p}$ peak and $Si_{2p3/2}$ peak of 4.1 eV has excellent dielectric strength.

Therefore, by applying the oxide film 2 to various insulator, e.g. gate insulating film, semiconductor device with excellent performance can be obtained. Furthermore, it is possible to decrease the thickness of insulator in various devices and use such film as, e.g. tunnel insulating film.

(Application To Industries)

The silicon oxide film of the present invention is characterized in that a bond energy of $Si_{2p}$ peak due to a silicon-oxygen bond is greater than that of $Si_{2p3/2}$ peak due to a silicon-silicon bond by more than 4.1 eV, and having excellent dielectric characteristic and is used as an etching mask or a tunnel insulating film.

The semiconductor device having such oxide film has a high conversion conductance and a high speed performance characteristic because of a short channel.

**Claims**

1. A silicon oxide film wherein a bond energy of an $Si_{2p}$ peak due to a silicon-oxygen bond is greater than that of an $Si_{2p3/2}$ peak due to a silicon-silicon bond by more than 4.1 eV in X-ray photoelectron spectrum.

2. A silicon oxide film according to claim 1, wherein a bond energy of an $Si_{2p}$ peak due to a silicon-oxygen bond is greater than that of an $Si_{2p3/2}$ peak due to a silicon-silicon bond by more than 4.7 eV.

3. A semiconductor device comprising MOS transistor which has said silicon oxide film described in claim 1 or 2 as an insulating film.

4. A semiconductor device according to claim 3, wherein said insulating film is a gate insulating film.

5. A semiconductor device according to claim 3, wherein said insulating film is a tunnel insulating film.

6. A semiconductor device according to claim 3 or 4, wherein the thickness of said insulating film is 0.5 through 10 nm.

7. A silicon oxide film according to claim 1, wherein said silicon oxide film is an oxide film used for a etching mask.

8. A semiconductor device according to claim 3 wherein at least a portion of insulating film for electrically isolating a gate electrode from a source and a drain electrodes is composed of metal fluoride.

# F i g. 1

# F i g .  2

# F i g . 3 (a)

# Fig. 3 (b)

# F i g . 3 (c)

# F i g . 3 (d)

# Fig. 3 (e)

# INTERNATIONAL SEARCH REPORT

International Application No   PCT/JP90/00582

| I. CLASSIFICATION OF SUBJECT MATTER (if several classification symbols apply, indicate all) [6] |
|---|
| According to International Patent Classification (IPC) or to both National Classification and IPC |

Int. Cl$^5$      H01L21/316, H01L29/784, H01L29/78

## II. FIELDS SEARCHED

### Minimum Documentation Searched [7]

| Classification System | Classification Symbols |
|---|---|
| IPC | H01L21/316 |

Documentation Searched other than Minimum Documentation
to the Extent that such Documents are Included in the Fields Searched [8]

| | |
|---|---|
| Jitsuyo Shinan Koho | 1926 - 1989 |
| Kokai Jitsuyo Shinan Koho | 1971 - 1989 |

## III. DOCUMENTS CONSIDERED TO BE RELEVANT [9]

| Category [*] | Citation of Document, [11] with indication, where appropriate, of the relevant passages [12] | Relevant to Claim No. [13] |
|---|---|---|
| X | JP, A, 63-29516 (Mitsubishi Electric Corp.), 8 February 1988 (08. 02. 88), (Family: none) | 1 - 11 |
| X | JP, A, 55-121653 (Fujitsu Ltd.), 18 September 1980 (18. 09. 80), (Family: none) | 1 - 11 |
| X | JP, A, 54-66075 (Mitsubishi Electric Corp.), 28 May 1979 (28. 05. 79), (Family: none). | 1 - 11 |
| X | JP, A, 51-114875 (Mitsubishi Electric Corp.), 8 October 1976 (08. 10. 76), (Family: none) | 1 - 11 |

* Special categories of cited documents: [10]

"A"  document defining the general state of the art which is not considered to be of particular relevance

"E"  earlier document but published on or after the international filing date

"L"  document which may throw doubts on priority claim(s) or which is cited to establish the publication date of another citation or other special reason (as specified)

"O"  document referring to an oral disclosure, use, exhibition or other means

"P"  document published prior to the international filing date but later than the priority date claimed

"T"  later document published after the international filing date or priority date and not in conflict with the application but cited to understand the principle or theory underlying the invention

"X"  document of particular relevance; the claimed invention cannot be considered novel or cannot be considered to involve an inventive step

"Y"  document of particular relevance; the claimed invention cannot be considered to involve an inventive step when the document is combined with one or more other such documents, such combination being obvious to a person skilled in the art

"&"  document member of the same patent family

## IV. CERTIFICATION

| Date of the Actual Completion of the International Search | Date of Mailing of this International Search Report |
|---|---|
| June 27, 1990 (27. 06. 90) | July 9, 1990 (09. 07. 90) |
| International Searching Authority | Signature of Authorized Officer |
| Japanese Patent Office | |

Form PCT/ISA/210 (second sheet) (January 1985)